Europäisches Patentamt

European Patent Office

Office européen des brevets

(19)

(11) **EP 1 217 752 A2**

(12) **DEMANDE DE BREVET EUROPEEN**

(43) Date de publication:
**26.06.2002 Bulletin 2002/26**

(51) Int Cl.⁷: **H03M 13/45**, H03M 13/29

(21) Numéro de dépôt: **01460059.7**

(22) Date de dépôt: **28.09.2001**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **02.10.2000 FR 0012501**

(71) Demandeur: **Sacet SA**
**35170 Bruz (FR)**

(72) Inventeurs:
• **Robert, Sophie**
  **35200 Rennes (FR)**
• **Testard, Marc**
  **56350 St Vincent sur Oust (FR)**

Remarques:
Les revendications 11,14-17 et 19-21 sont reputées abandonnées pour défaut de paiement de la taxe de revendication (règle 31 (2) CBE).

(54) **Procédé de décodage itératif associé à toutes concaténations d'un nombre déterminé de codes en blocs ou assimilés**

(57) Le procédé effectue de façon itérative une décomposition en décodages élémentaires au moyen d'un décodeur du type à "entrée souple/sortie souple". Il permet à partir d'une information dite de fiabilité a priori sur les symboles émis du code, de calculer (12,...15) des valeurs de fiabilités a posteriori dans lequel les valeurs de fiabilité a posteriori deviennent des valeurs de fiabilité a priori pour initialiser le décodage à chaque nouvelle itération, les valeurs de fiabilité a posteriori étant calculées à partir d'une valeur dite valeur extrinsèque qui tient compte des informations disponibles sur chacun des symboles reçus.

Applications: Systèmes de transmission radioélectriques numériques.

FIG -4-

EP 1 217 752 A2

**Description**

La présente invention concerne un procédé de décodage Itératif associé à toutes concaténations d'un nombre déterminé P de codes en blocs ou assimilés, binaire ou à écriture binaire.

Elle s'applique notamment à la réalisation de systèmes de transmission radioélectrique numériques.

Un schéma simplifié d'un système de transmission radioélectrique numérique peut être vu comme comportant une source binaire, un dispositif de codage de canal et un modulateur. De manière symétrique, le récepteur est constitué d'un démodulateur et d'un décodeur. Le codage de canal intervient au niveau de la protection de la transmission permettant ainsi, soit de diminuer le taux d'erreurs binaires, soit de limiter la puissance d'émission soit les deux. Il est important d'établir un bon compromis entre ces deux contraintes. Cependant, les progrès de la technologie permettent d'implanter des codeurs très sophistiqués et d'obtenir ainsi de très bons compromis.

Une des plus importantes possibilités consiste à effectuer des concaténations de plusieurs codes. Ces concaténations peuvent être faites en série, en parallèle ou hybrides. En notant par $(C_1)_{1 \le i \le p}$ les codes en bloc qui peuvent être binaires ou symboliques de longueur $n_i$, de dimension $k_i$ et de distance de Hamming minimale $d_{H_i}$, les $l_i$ mots issus du code $C_1$ sont, dans les concaténations en série, à nouveau codés après entrelacement par le code $C_{1+1}$ pour finalement générer un code équivalent de longueur $l_p n_p$ et de rendement $\frac{l_1 k_1}{l_p n_p}$. Dans les concaténations en parallèle, il s'agit de coder la même information par $p$ codes de même dimension via $p$ entrelacements différents de cette information émise, ces entrelacements étant de taille $lk_i$. Le mot obtenu est donc la concaténation de $p$ mots et est de longueur

$$l \sum_{i=1}^{p} n_i$$

ou si les symboles utiles ne sont émis qu'une fois

$$l \left( k_1 + \sum_{i=1}^{p} (n_i - k_i) \right).$$

Les schémas les plus utilisés sont les codes produits à 2 ou 3 dimensions qui consistent en une concaténation en série (ou parfois en parallèle) de 2 ou 3 codes en blocs. Il s'agit alors de représenter l'information comme une matrice de taille $k_2 \times k_1$. Les $k_2$ lignes sont alors encodées par le code $C_1(n_1,k_1)$ puis les $n_1$ colonnes résultantes par le code $C_2(n_2,k_2)$. Le mot final, toujours sous forme matricielle, est de taille $n_2 \times n_1$. Pour le code produit en trois dimensions, la taille initiale est $k_3 \times k_2 \times k_1$ et les $k_3 \times k_2$ lignes sont codées par $C_1(n_1,k_1)$, les $k_3 \times n_1$ colonnes résultantes par $C_2(n_2,k_2)$ et enfin les $n_2 \times n_1$ lignes transversales par $C_3(n_3,k_3)$ pour former un mot total de taille $n_3 \times n_2 \times n_1$.

Pour ces deux types de concaténation, les entrelacements sont les transposées et ainsi leur principale propriété est que le codage de la redondance du code $C_1$ par le code $C_j$ est égale au codage de la redondance du code $C_i$ par le code $C_i$, avec $1 \le i < j \le 3$. Cette propriété renforce l'efficacité du schéma de codage.

Dans tous les cas, la concaténation peut être vue comme un unique code. Cependant en terme de décodage, ce point de vu mène à une solution trop complexe et tout l'intérêt est d'utiliser sa décomposition en mots élémentaires relatifs aux codes $C_1$.

La présente invention propose un décodage générique pour toutes concaténations de $p$ codes en blocs. Ce décodage est un décodage itératif de complexité raisonnable avec de plus de bonnes propriétés pour une implantation efficace. Il est adapté pour des transmissions qui exigent de faibles taux d'erreurs binaires et une faible puissance d'émission. Il est également adapté pour l'émission de paquets de données courts et indépendants.

La plus ancienne solution de décodage des concaténations consiste à exploiter la décision à seuil à la sortie du démodulateur. En effet à partir de cette décision, une valeur ferme est attribuée à chaque symbole reçu et un décodage algébrique est appliqué à chaque mot élémentaire relatif à $C_1$. Non seulement cette solution dépend de la structure algébrique de chaque code utilisé via son décodeur mais elle présente également le grand inconvénient de réduire le gain de codage en n'exploitant qu'une partie de l'information disponible en sortie du démodulateur. Il est alors très difficile d'en déduire un système itératif.

A la sortie du démodulateur, une valeur dite souple est également disponible qui renseigne sur la fiabilité de la réception. Cette information permet d'envisager un système itératif. En effet ces valeurs de fiabilités sont des valeurs *a priori* que le décodage va confirmer ou infirmer en définissant de nouvelles fiabilités dites *a posteriori*. Ces valeurs deviendront des valeurs *a priori* pour l'itération suivante. Il est donc clair que la base de ce schéma est un décodeur à entrée et sortie souples encore connu sous la désignation anglo-saxonne de décodeur SISO qui est l'abréviation de " Soft Input Soft Output" et un enchaînement des itérations via la définition des valeurs *a priori* et des valeurs *a posteriori*.

Dans ce contexte, la demande de brevet français FR-A-2 712 760 et le brevet des Etats Unis d 'Amérique US 5-930-272 décrivent deux solutions différentes qui utilisent respectivement un décodage de Chase modifié et un algorithme dit pseudo maximum de vraisemblance. Dans les deux cas, ces algorithmes dépendent entièrement des codes choisis. Le premier oblige à utiliser un décodeur algébrique spécifique pour chaque code $C_1$. Le deuxième s'appuie sur le spectre du code et ne peut s'appliquer qu'à des codes bien connus et relativement courts.

Une autre solution décrite dans la demande de brevet français FR 9805612 présente l'avantage qu'elle utilise un décodage élémentaire qui est générique pour tous codes en bloc. Cependant le schéma itératif utilisé analogue à celui préconisé par la demande de brevet français FR-A-2712-760 travaille avec des valeurs de pondération expérimentales et des valeurs pré - définies en cas d'échec du calcul des sorties souples. Ces deux points associés à une restriction du nombre d'itérations qui ne peut être contrôlé au cours de décodage, limitent la souplesse et l'efficacité de ces solutions.

Le but de l'invention est de pallier les inconvénients précités en proposant une mise en oeuvre de la technique de décodage à entrée souple dit par ré - ordonnancement et retraitement, du type décrite par MM Fossorier et Lin, dans la revue IEEE Trans on Information Theory, 41(5), 1995 ayant pour titre : *Soft décision decoding of linear block codes based on ordered statistics.* au sein d'un décodage itératif et générique pour tout type de concaténation.

A cet effet, l'invention a pour objet un procédé de décodage itératif pour toutes concaténations d'un nombre déterminé *p* de codes en blocs, ou assimilés, binaire ou à écriture binaire par décomposition en décodages élémentaires au moyen d'un décodeur du type à "entrée souple/sortie souple", permettant à partir d'une information dite de fiabilité *a priori* sur les symboles émis du code, de calculer des valeurs de fiabilités *a posteriori* dans lequel les valeurs de fiabilité *a posteriori* deviennent des valeurs de fiabilité *a priori* pour initialiser le décodage à chaque nouvelle itération, les valeurs de fiabilité *a posteriori* étant calculées à partir d'une valeur dite valeur extrinsèque qui tient compte des informations disponibles sur chacun des symboles reçus, caractérisé en ce qu'il consiste:

- à ordonnancer à chaque itération les décodages élémentaires en *p* ensembles $U_i$ de mots relatifs à chaque code $C_i$ dans l'ordre décroissant de leur nombre de dépendance avec les mots reçus et de la capacité de correction des codes,

- à garantir le calcul des valeurs extrinsèques des symboles représentés dans chaque ensemble $U_i$ par un décodage élémentaire de chaque mot de l'ensemble $U_i$,

- à calculer des valeurs *a posteriori* de chaque symbole représenté dans chaque ensemble $U_i$ en effectuant la somme des valeurs reçues et des valeurs extrinsèques pondérées en fonction du nombre de symboles différents entre la décision ferme des valeurs a priori et la décision ferme issue des décodages élémentaires de l'itération courante,

- et à arrêter les itérations en fonction du même nombre de symboles différents entre la décision ferme des valeurs a priori et la décision ferme issue des décodages élémentaires de l'itération courante, pour ne conserver que la décision ferme des dernières valeurs a posteriori.

Grâce à un décodeur garantissant toujours une sortie souple et une pondération calculée au cours des itérations, le décodage réalisé selon l'invention est réellement générique au sens où le procédé de décodage itératif qui est mis en oeuvre peut être appliqué à toutes concaténations d'un nombre déterminé de *P* codes en bloc quels que soient les types de codes qui composent une concaténation. Il est à noter qu'un code convolutif peut être vu comme un code en bloc lorsqu'il est réduit aux mots de longueur *n* donnée.

De plus, il permet un contrôle algorithmique des itérations. Ce contrôle induit à la fois une réduction du nombre moyen d'itérations à effectuer mais également dans les cas critiques une prolongation du nombre de décodage jusqu'à une borne maximale qui est plus grande que pour les solutions précédentes.

D'autres caractéristiques et avantages de l'invention apparaîtront à la lumière de la description qui suit faite en regard des dessins annexés qui représentent :

La figure 1 un schéma d'organisation général d'un système de transmission radioélectrique numérique de l'information.

La figure 2 un exemple de mise en oeuvre selon l'invention d'un processus de décodage par ré-ordonnancement et retraitement sous la forme d'un organigramme.

La figure 3 un schéma général illustrant le principe d'un décodeur itératif.

Les figures 4 et 6 un premier et un deuxième mode de réalisation d'un décodage itératif selon l'invention.

La figure 5 le processus de calcul des valeurs extrinsèques mis en oeuvre dans les modes de réalisation des figures 4 et 6.

La figure 7 les performances obtenues par simulation du décodage itératif appliqué au code produit à deux dimensions avec $C_1 = C_2$ un code BCH étendu de paramètres (32,21,6).

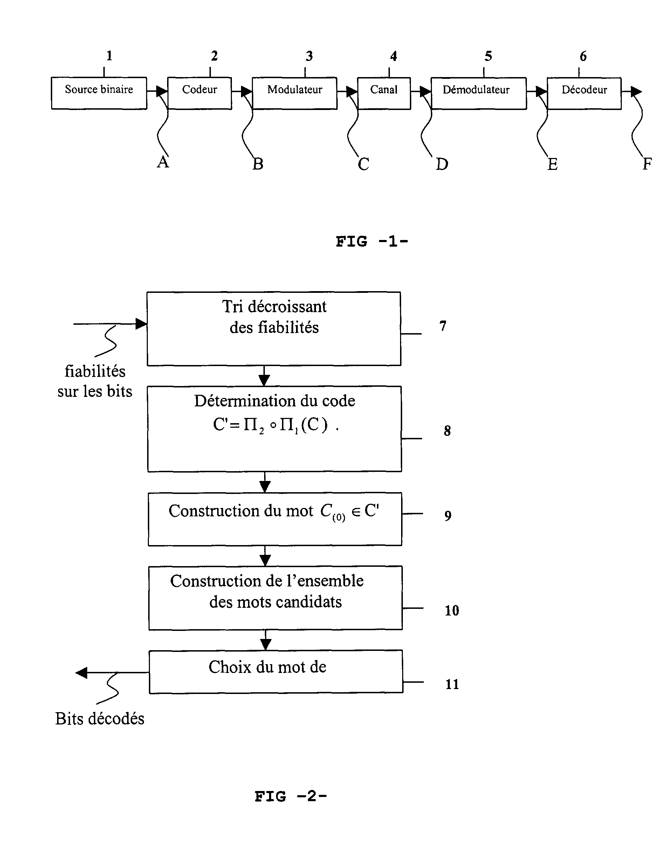

En préliminaire à la description de l'invention, il est nécessaire de définir les acquis sur lesquels elle s'appuie, en rappelant ci après les principes généraux de démodulation sur canal numérique, le principe général du décodage itératif et le principe du décodage de MM Fossorier et LIN sur lesquels s'appuie le procédé de décodage de l'invention.
Un schéma simplifié d'un système de transmission numérique par voie hertzienne peut être vu comme comportant de la façon représentée à la figure 1, une source binaire 1, un dispositif de codage de canal 2 et un modulateur 3 reliés dans cet ordre en série. De manière symétrique, le récepteur est constitué d'un démodulateur 5 suivi d'un décodeur 6. Sur la figure 1 le canal de transmission référencé 4 est situé entre la sortie du modulateur 3 et l'entrée du démodulateur 5. Suivant cette configuration les bits ou symboles d'information A fournis par la source binaire 1 sont transformés en bits ou symboles B codés par le dispositif de codage 2 pour être ensuite modulés en bits ou symboles C par le modulateur 3. En sortie du canal 4 les valeurs reçues D sont démodulées en valeurs E par le démodulateur 5 pour être ensuite décodées en bits ou symboles F par le décodeur 6.
La sortie du démodulateur 5, fournit une information de fiabilité sur la valeur du symbole émis qui prend la forme d'un rapport de vraisemblance. Pour simplifier les descriptions, il est considéré ci après que le canal est gaussien et que le signal fourni par le modulateur 3 est supposé être un signal modulé suivant la modulation connue sous l'abréviation anglo-saxonne BPSK de "Binary Phase Shift Keying". Le procédé selon l'invention peut cependant s'appliquer à d'autres formes de modulation ainsi qu'à d'autres formes de modélisation de canal. En modulation BPSK chaque état binaire (0,1) d'un symbole d'information est transmis suivant un signal à deux états symétriques respectivement (1, -1). Dans ce cas, le signal démodulé obtenu en sortie du démodulateur 5 est un signal de la forme $y=b^*+\omega$ où $b^*$ est le bit d'information émis modulé et $\omega$ un bruit blanc additif gaussien de moyenne nulle et de variance $\sigma^2$. La fiabilité associée au bit émis $b$ est alors donnée par la relation:

$$F(b) = \log = \frac{P(b = 0/y)}{P(b = 1/y)} = \frac{2}{\sigma^2}y \qquad (1)$$

lorsque les probabilités $P(b=0)=P(b=1) = \frac{1}{2}$. Ainsi, initialement la fiabilité est proportionnelle à la valeur souple du signal obtenu en sortie du démodulateur 5.
Pour un symbole codé émis, une nouvelle information de fiabilité est donnée par

$$F(b) = \log \frac{\sum_{C \in C, C_i = 0} P(C/Y)}{\sum_{\widetilde{C} \in C, \widetilde{C}_i = 1} P(\widetilde{C}/Y)} \qquad (2)$$

si $b$ désigne la position $i$ d'un mot du code et $Y$ le mot reçu. Pour un code long ce rapport est généralement réduit à son terme principal

$$F(b) = \log \frac{P\left(C^{(0)}/Y\right)}{P\left(C^{(1)}/Y\right)} = \frac{1}{2\sigma^2}\left(\left\|Y - C^{(1)^*}\right\|_2^2 - \left\|Y - C^{(0)^*}\right\|_2^2\right) \qquad (3)$$

où C(o) (respectivement C(1)) réalise la plus petite distance euclidienne au mot reçu parmi l'ensemble des mots de dont la position b vaut 0 (respectivement 1). Les mots C(o) et C(1) sont appelés dans ce contexte les mots concurrents.

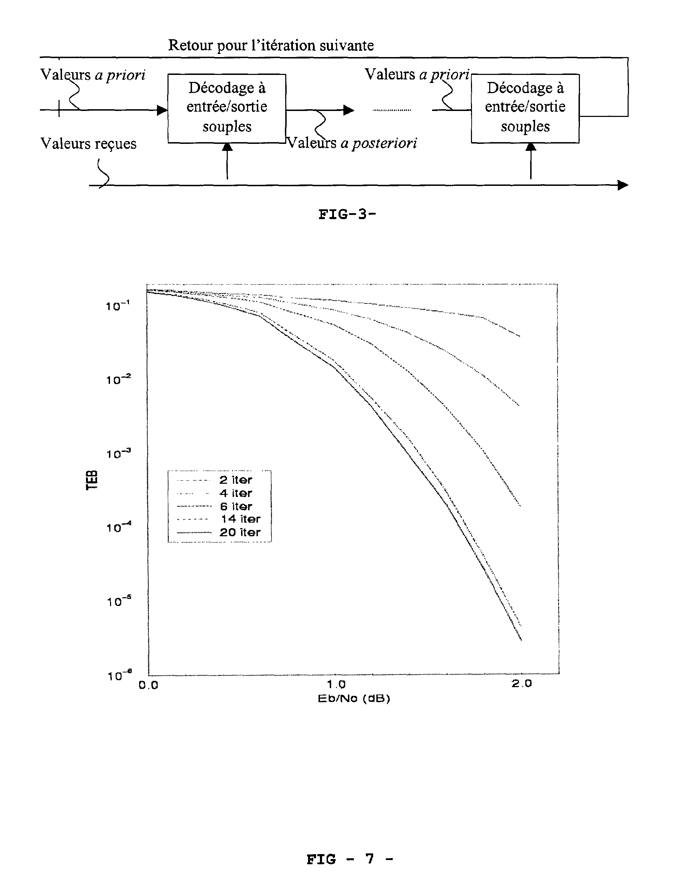

Le principe général d'un décodage itératif est illustré par la figure 3. A partir d'une fiabilité dite *a priori* sur les bits émis, le but est de calculer des valeurs de fiabilités *a posteriori* qui vont confirmer ou infirmer les fiabilités initiales. Ainsi, pour l'itération suivante, les valeurs *a posteriori* vont devenir des fiabilités *a priori* initialisant le processus itératif. Les valeurs de fiabilité *a posteriori* sont déterminées grâce à une information supplémentaire appelée valeur extrinsèque qui doit être indépendante de celle portée directement par le bit. Cette valeur extrinsèque est issue d'un décodage qui tient compte de toutes les informations disponibles sur le symbole à la position *i* exceptée celle issue de la valeur reçue qui lui est associée. Il est choisi comme définition de la valeur extrinsèque de la position *i* la fiabilité

$$ext(symbole) = \frac{1}{2\sigma^2}\left(\left\|\widetilde{Y} - \widetilde{C}^{(1)\bullet}\right\|_2^2 - \left\|\widetilde{Y} - \widetilde{C}^{(0)\bullet}\right\|_2^2\right) = \frac{2}{\sigma^2}\sum_{\substack{j=1 \\ j\neq i}}^{n} Y_j\alpha_j \quad \alpha_j = \begin{matrix} 1 & C_j^{(0)} \neq C_j^{(1)} \\ 0 & \text{sinon} \end{matrix}$$

où $\widetilde{X}$ désigne la suppression de la composante *i* du vecteur *X*. Comme toutes les valeurs sont proportionnelles à $\frac{2}{\sigma^2}$ ce coefficient pourra être omis dans la suite des calculs.

Au cours de la description des procédés relatifs à l'invention, le mode de calcul des valeurs extrinsèques et des valeurs *a posteriori* qui s'en déduit sera d'avantage détaillé. L'algorithme par ré - ordonnancement et retraitement de MM Fossorier et LIN utilisé pour la mise en oeuvre du procédé selon l'invention est un décodage à entrée souple et sortie ferme.

Il est rappelé qu'un code en bloc linéaire est une fonction de $A^k \rightarrow A^n$ où *A* est un corps de Galois de dimension *q*, par exemple dans le cas binaire si *q*=1, *A*={0,1}.

Le code peut être défini par une matrice *G* dite génératrice de dimension $k \times n$ sur *A* qui permet de construire les mots du code de la façon suivante

$$C=(c_1 \ ... \ c_k)G$$

où $(c_1 \ ... \ c_k)$ sont appelés les symboles utiles. De plus si cette matrice est sous la forme suivante :

$$G=(I,P) \tag{4}$$

avec *I* la matrice identité de dimension $k^2$ et *P* une matrice de dimension $k \times (n-k)$, elle est dite sous forme systématique. Le mot de code s'écrit alors

$$C=(c_1 \ ... \ c_k)G=(c_1 \ ... \ c_k \ c_{k+1} \ ... \ c_n)$$

et les symboles $(c_{k+1} \ ... \ c_n)$ sont appelés symboles de parité ou symbole de redondance.

Une matrice *H* dite de parité est également définie et renseigne sur l'appartenance au code d'un mot de longueur *n* appartenant à An. Puisque le produit de *G* et de la transposée de *H* est nul l'équivalence suivante est vérifiée:

$$CH^\perp = 0 \Leftrightarrow C \in$$

Pour tout mot de longueur *n* son produit avec $H^\perp$ est appelé syndrome.

Un mode d'exécution de l'algorithme de décodage par ré-ordonnancement et retraitement de MM Fossorier et LIN est figuré par les étapes référencées de 7 à 11 sur la figure 2. Dans cette description désigne le code en bloc utilisé de paramètre (*n,k*) et *y* désigne le vecteur des valeurs de fiabilité en entrée du décodeur. Par la suite, la lettre F sera utilisée pour désigner ce procédé ou F( ) pour préciser à quel code il s'applique.

Selon la première étape référencée 7 sur la figure 2, les $n-d_H^\perp+1$ plus petites valeurs en entrée sont triées en ordre décroissant de leur valeur absolue. Ce tri engendre une première permutation $\Pi_1$ de longueur *n*. Il est possible également de trier l'intégralité des valeurs reçues lorsque par exemple la distance $d_H^\perp$ n'est pas connue.

Au cours de la deuxième étape référencée 8, un code C équivalent au code initial est déterminé. La matrice de parité dont les colonnes ont été permutées par $\Pi_1$ est mise sous forme systématique de droite à gauche selon la convention adoptée par la relation (4). Lorsqu'un vecteur colonne est trouvé linéairement dépendant des précédents, il est rejeté de la partie identité induisant ainsi une deuxième permutation $\Pi_2$ tel que C'=$\Pi_2$o$\Pi_1$(C . De cette manière, les nouvelles positions de redondance du code C' correspondent aux valeurs reçues $(y_{\Pi_2 o \Pi_1(i)})_{k+1 \le i \le n}$ telles que $\left|y_{\Pi_2 o \Pi_1(k+1)}\right| \ge \left|y_{\Pi_2 o \Pi_1(k+2)}\right| \ge ... \ge \left|y_{\Pi_2 o \Pi_1(n)}\right|$ et telles que les valeurs $(y_{\Pi_2 o \Pi_1(i)})_{1 \le i \le k}$ relatives aux symboles utiles pour C' contiennent le plus grand nombre des $k$ plus grandes valeurs de fiabilité en valeur absolue.

La troisième étape référencée 9 consiste à définir à partir de la décision ferme des fiabilités relatives aux nouveaux symboles utiles, un mot $C_{(0)}$ appartenant au code C. Il est défini par correction des nouveaux symboles de redondance via le syndrome de la décision ferme ci-dessus. De plus, ce mot $C_{(0)}$ est un mot candidat dont la distance euclidienne avec le mot souple en entrée permuté par $\Pi_2 o \Pi_1$ est déterminée.

A la quatrième étape référencée 10, sur la décision ferme des fiabilités qui correspondent aux nouveaux symboles utiles, sont appliqués des motifs d'erreurs afin de définir un ensemble de mots $C_{(i)}$ appartenant au code C. Cette construction s'effectue également par la modification de la nouvelle redondance via le syndrome. Leur distance euclidienne avec le mot souple en entrée permuté par $\Pi_2 o \Pi_1$ est aussi déterminée.

Enfin la dernière étape référencée 11, retient le mot $C_{(l)}$ appartenant à qui réalise la plus petite distance euclidienne au mot souple reçu permuté par $\Pi_2 o \Pi_1$. Le mot ferme décodé est $(\Pi_2 o \Pi_1)^{-1}(C_{(l)})$. La sortie ferme du procédé F sera notée $C^{(F)}$ dans la suite des descriptions. Les trois premières étapes constituent le décodage par ré-ordonnancement et les deux dernières constituent le décodage par retraitement.

Lorsque les motifs d'erreurs sont constitués de tous les motifs de poids $\le i$ le retraitement est dit d'ordre $i$.

L'algorithme de MM Fossorier et LIN a été décrit à partir de sa représentation par rapport à la matrice de parité. Il existe également une représentation équivalente par rapport à la matrice génératrice. Il s'agit alors de trier les $n-d_H+1$ plus grandes fiabilités en ordre décroissant de leur valeur absolue et de travailler sur la matrice génératrice permutée pour définir le code équivalent C'=$\Pi_2 o \Pi_1$(C. Les nouvelles positions des symboles utiles correspondent aux valeurs reçues $(y_{\Pi_2 o \Pi_1(i)})_{1 \le i \le k}$ telles que $\left|y_{\Pi_2 o \Pi_1(1)}\right| \ge \left|y_{\Pi_2 o \Pi_1(2)}\right| \ge ... \ge \left|y_{\Pi_2 o \Pi_1(k)}\right|$ et telles que les valeurs $(y_{\Pi_2 o \Pi_1(i)})_{k+1 \le i \le n}$ relatives aux nouvelles positions de redondance contiennent le plus grand nombre des $n-k$ plus petites fiabilités en valeur absolue. Les mots $C_{(i)} \in$ sont alors obtenus simplement par construction du mot de code C dont les symboles utiles sont les décisions fermes des fiabilités $(y_{\Pi_2 o \Pi_1(i)})_{1 \le i \le k}$. Dans la suite de la description les explications se limiteront toujours au procédé F par rapport à la matrice de parité.

Dans cet ensemble de mots, le mot de l'ensemble qui minimise la distance euclidienne au mot reçu est recherché. De manière évidente, ceci est équivalent à chercher le mot qui maximise le produit scalaire par rapport au mot reçu. Or, ce produit scalaire se décompose en

$$\left\langle Y, C^{*}_{(i)} \right\rangle = \left\langle Y, \overline{Y}^{*} \right\rangle - 2 \sum_{l=1}^{n} e_l^{(i)} \left|Y_l\right| \qquad (5)$$

avec $\overline{Y}$ la décision ferme associée à $Y$ et $(e_l^{(i)})_{1 \le l \le n}$ le vecteur binaire tel que si les positions $l$ de $\overline{Y}$ et de $C_{(i)}$ diffèrent alors $e_l$=1 et $e_l$=0 sinon. Le terme $\langle Y, \overline{Y}^{*} \rangle$ étant constant, la métrique choisie et qui doit être minimisée, est celle donnée par la relation :

$$d_i = \sum_{l=1}^{n} e_l^{(i)} \left|Y_l\right| \qquad (6)$$

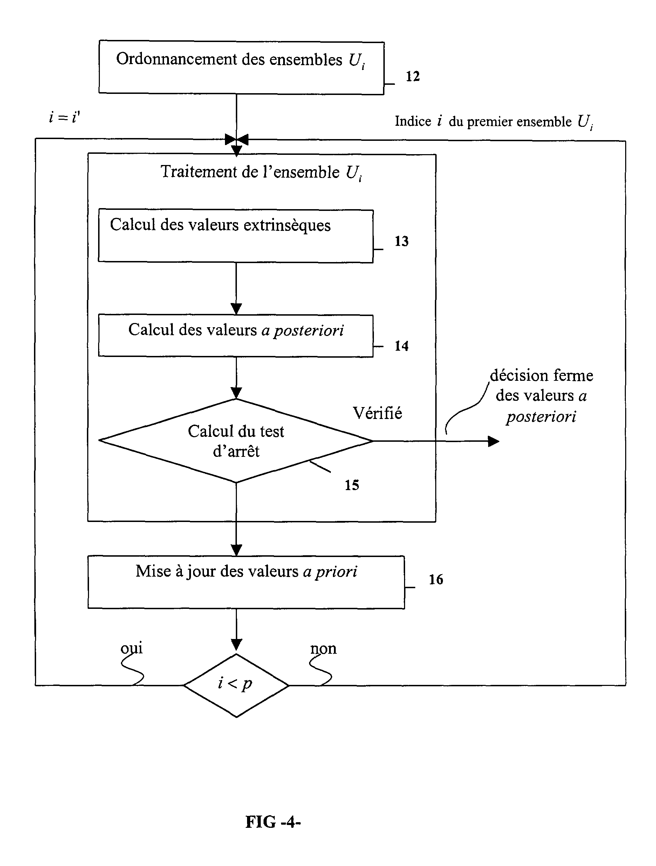

L'invention propose d'utiliser le principe général du décodage itératif décrit ci-dessus à partir d'un décodeur SISO qui s'appuie sur le procédé F pour calculer les valeurs extrinsèques. Dans ce qui suit les procédés de calcul des valeurs *a priori* et *a posteriori* qui sont des valeurs de fiabilités, ainsi que l'enchaînement des itérations sont détaillés en référence aux organigrammes des figures 4 à 6 .

Pour simplifier la description du procédé selon l'invention, le résultat de la concaténation est représenté par l'ensemble $(U_1, \cdots, U_p)$ où $U_i$ représente l'ensemble des mots émis relatifs au code C$_i$. Par exemple, pour le code produit à deux dimensions, la concaténation est décrite par deux ensembles $U_1$ et $U_2$ qui représentent respectivement les lignes et les colonnes de la matrice. Par la suite les notations suivantes sont adoptées. Si $U_i$ est l'ensemble relatif aux $p_i$ mots du code C$_i(n_i, k_i)$ , $(u_{il})_{1 \le l \le p_i}$ désignent les mots émis, $(y_{il})_{1 \le l \le p_i}$ désignent les mots reçus, $(ap_{il}^{(j)})_{1 \le l \le p_i}$ désignent les vecteurs des valeurs a priori de l'itération $j$, $(ext_{il}^{(j)})_{1 \le l \le p_i}$ désignent les vecteurs des valeurs extrinsèques calculées à l'itération $j$ et $(app_{il}^{(j)})_{1 \le l \le p_i}$ désignent les vecteurs des valeurs *a posteriori* calculées à l'itération $j$.

Suivant un premier mode de réalisation, noté P1, du procédé de décodage itératif appliqué à une concaténation de $p$ codes selon l'invention, le décodage consiste à décoder successivement les mots de chaque ensemble $U_i$. Ce procédé est exécuté suivant les étapes référencées de 12 à 16 sur la figure 4.

L'étape 12 est une étape préliminaire aux itérations qui permet de définir l'ordre de traitement des mots élémentaires appartenant aux ensembles $U_i$. Ainsi ces ensembles $U_i$ sont ordonnés dans un premier temps en fonction du maximum de dépendance entre les mots de $U_i$ et toutes les valeurs reçues puis en fonction des capacités de correction des codes $C_i$. Par exemple, pour une concaténation en série de deux codes avec entrelacement aléatoire, l'ensemble $U_1$ relatif au code interne $C_1$ est traité avant l'ensemble $U_2$ représentant les mots du code externe $C_2$. En revanche, pour le code produit à deux dimensions, l'ensemble relatif au code qui possède la meilleure capacité de correction est traité en premier.

Dans ce procédé, une itération est définie comme le traitement de l'ensemble des mots de $U_i$ relatifs au code $C_i$.

L'étape 13 consiste à calculer les valeurs extrinsèques de tous les symboles représentés dans $U_i$ par décodage SISO de tous les mots élémentaires du code $C_i$ qui ont été émis.

A l'étape 14 les *valeurs a posteriori* sont calculées. Les valeurs *a posteriori* sont représentées comme la somme des valeurs reçues et des valeurs extrinsèques pondérées non pas par des valeurs expérimentales mais par une valeur algorithmique.

L'étape 15 permet de stopper les itérations en fonction du calcul des valeurs *a posteriori.* En effet sans critère d'arrêt le nombre d'itérations $L$ ne peut varier et doit être fixé assez petit pour des raisons de complexité. L'invention préconise l'utilisation de deux critères d'arrêt qui permettent d'augmenter $L$ puisqu'en moyenne la plus grande partie des décodages au cours de la transmission seront stoppés avant ces $L$ itérations.

L'étape 16 permet de calculer les valeurs *a priori* si le critère d'arrêt n'est pas vérifié. Selon l'ordonnancement de la première étape 12 un calcul des valeurs *a priori* $(ap_{i'l}^{(j+1)})_{1\leq i'\leq p'_i}$ relatif à l'ensemble $U_{i'}$ qui suit $U_i$ est exécuté. Le procédé ici est simple puisque pour tout symbole n'appartenant pas à l'intersection de $U_i$ et $U_{i'}$ la valeur *a priori* est inchangée si non la valeur a *posteriori* calculée à l'itération $j$ devient la valeur a priori de l'itération $j+1$.

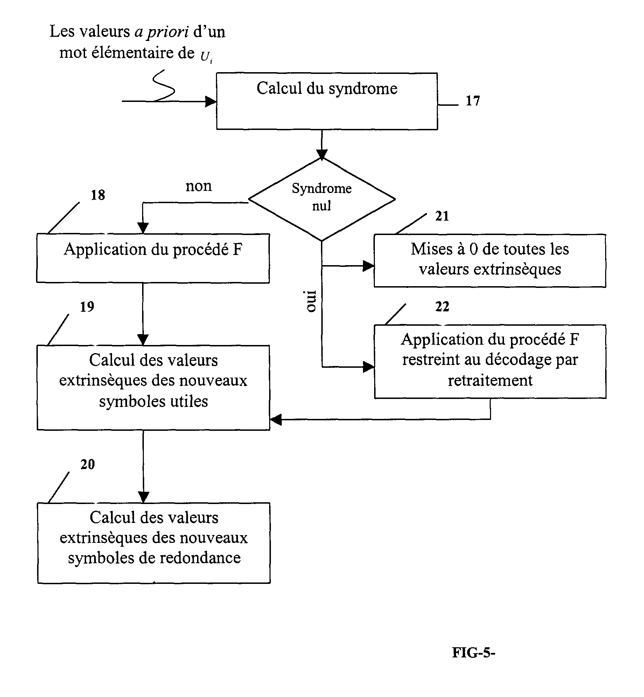

Un mode d'exécution détaillé de l'étape 13 est montré à la figure 5. Son mode de réalisation permet au procédé de garantir l'existence d'une valeur extrinsèque sans l'utilisation d'aucun coefficient expérimental. Pour cela le procédé de MM Fossorier et LIN décrit à la figure 2 est avantageusement exploité et en particulier l'ensemble qu'il construit et qui permet de déterminer les valeurs extrinsèques. Le procédé d'exécution de l'étape 13 comporte six étapes principales de traitement référencées de 17 à 22 sur la figure 5. Cette étape, si $j$ désigne l'itération, se décompose par mot élémentaire représenté par $y_{il}$ et $ap^{(j)}$ de la façon suivante.

Selon la première étape référencée 17 le syndrome relatif aux décisions fermes des valeurs *a priori* $ap_{il}^{(j)}$ est calculé comme le produit de ces décisions fermes et de la matrice de parité transposée.

A l'étape 18 si le syndrome est non nul, le procédé $F(C_i)$ de la figure 2 est appliqué avec un retraitement incluant un retraitement d'ordre 1 total à partir des valeurs *a priori* $ap_{il}^{(j)}$. La mise en forme systématique peut être réalisée en mettant en oeuvre l'algorithme connu du pivot de Gauss appliqué à la matrice de parité dont les colonnes ont été permutées selon le tri induit par la permutation $\Pi_1$ et ceci de droite à gauche. Au cours du pivot de Gauss, tout vecteur linéairement dépendant des précédents est rejeté de la partie identité de manière à assurer que les fiabilités des nouveaux symboles utiles contiennent le plus grand nombre des $k_i$ plus grandes fiabilités *a priori* en valeur absolue.

Une variante de ce procédé peut consister à appliquer le procédé $F(C_{il}^{(j)})$ où $C_{il}^{(j)}$ est le code équivalent à $C_i$ issu de la mise en forme systématique effectuée lors du précédent traitement du mot $u_{il}$. Dans un premier temps, la permutation $\Pi$ issue du précédent traitement est appliquée au vecteur des valeurs *a priori* en entrée du décodeur SISO. Puis la nouvelle permutation $\Pi_1$ est déterminée ainsi que la mise en forme systématique de la matrice de parité issue du précédent traitement du mot $u_{il}$. Finalement sont conservées en mémoire la permutation globale $\Pi = \Pi_2 o \Pi_1 o \Pi$ et la nouvelle matrice de parité. Ce procédé est significatif pour diminuer la complexité du pivot de Gauss lorsque l'ensemble des positions considérées comme les plus fiables sont peu modifiées entre deux itérations car les $n-k$ derniers vecteurs de la matrice de parité contiennent de nombreux vecteurs de poids 1 préalablement au pivot de Gauss ($\Pi_1$ calculé ici est très proche de l'identité).

A l'étape 19 à partir de l'ensemble , la valeur extrinsèque des $k_i$ nouveaux symboles utiles dans la nouvelle base est calculée comme la différence

$$(\overline{ext}_{il}^{(j)})_m = (d_m^{(1)}) - (d_m^{(0)}) - (\Pi_2 o \Pi_1 (ap_{il}^{(j)}))_m \quad 1 \leq m \leq k_i \tag{7}$$

avec $d_m^{(0)}$ (respectivement $d_m^{(1)}$) la métrique donnée par la relation (6) associée au mot $C_m^{(0)}$ (respectivement $C_m^{(1)}$) appartenant à la restriction de aux mots dont la position $m$ vaut 0 (respectivement 1) et réalisant la plus petite distance euclidienne aux valeurs *a priori* dans cette restriction. Les mots $C^{(0)}$ et $C^{(1)}$ sont appelés les mots concurrents respectifs à la position $m$. Ils sont d'autant plus proches des mots $C^{(0)}$ et $C^{(1)}$ définis par la relation (3) que l'ordre de retraitement est grand et bien choisi.

Afin d'augmenter la précision des valeurs extrinsèques, il est également possible, selon une autre variante de réalisation et au prix d'une complexité plus importante, de calculer les valeurs extrinsèques en tenant compte de tous les mots de l'ensemble . Ce procédé s'appuie sur la relation suivante

$$\overline{ext}_{il}^{(j)} = \frac{\sigma^2}{2} \log \frac{\displaystyle\sum_{C \in E, C_l = 0} e^{-\frac{1}{2\sigma^2}\|Y - C^*\|_2^2}}{\displaystyle\sum_{\tilde{C} \in E, \tilde{C}_l = 1} e^{-\frac{1}{2\sigma^2}\|Y - \tilde{C}^*\|_2^2}} \qquad (8)$$

qui ne permet pas de choisir pour métrique celle donnée par la relation (6) mais qui impose la distance euclidienne. De plus elle nécessite de connaître la variance du bruit et complique la quantification de l'algorithme. Le mode de réalisation préférentiel de l'invention est donc le procédé décrit par la première variante.

De plus, l'invention permet de faire varier les ordres de retraitement au cours des itérations. A partir d'un retraitement plus important pour les premières itérations, puis limité à un ordre 1 par la suite, la relation (7) constitue une bonne définition de la valeur extrinsèque.

Enfin l'étape 20 définit pour chaque nouveau symbole de redondance, la valeur extrinsèque à partir de celles des symboles utiles. En effet comme $cH^{\perp}=0$, chaque symbole de redondance est par conséquent relié aux symboles utiles par une équation dite de parité telle que:

$$(\overline{ext}_{il}^{(j)})_m = sign(\prod_{q=1}^{k_i} h'_{(m-k_i)q}(d_q^{(1)} - d_q^{(0)})) \min_{1 \le q \le k_i}(\left\|h'_{(m-k_i)q}(d_q^{(1)} - d_q^{(0)})\right\|) - (\overline{ap}_{il}^{(j)})_m \quad (9)$$

Avec $k_i + 1 \le m \le n_i$
où $(\overline{ap}_{il}^{(j)})$ est le vecteur des valeurs a priori permuté par $\Pi_2 o \Pi_1$ et où :

$$H' = (h'_{qr})_{\substack{1 \le q \le n_i - k_i \\ 1 \le r \le n_i}}$$

est la matrice de parité issue de la mise en forme systématique.

Dans un mode de réalisation différent, lorsque les mots $C_m^{(0)}$ et $C_m^{(1)}$ sont présents dans l'ensemble , la valeur extrinsèque relative au symbole de redondance en position $m$ dans la nouvelle base peut être définie également à partir de la relation (7) ou (8). Mais dans tous les cas si le retraitement est suffisant donc s'il comprend un ordre de retraitement d'ordre 1, l'existence d'une valeur extrinsèque pour tous les symboles du mot élémentaire traité est garantie.

Finalement $(ext_{il}^{(j)}) = (\Pi_2 o \Pi_1)^{-1}(\overline{ext}_{il}^{(j)})$. si le procédé F($C_i$) a été utilisé ou $(ext_{il}^{(j)}) = (\Pi)^{-1}(\overline{ext}_{il}^{(j)})$ si le procédé F($C_{il}^{(j)}$) a été choisi.

L'étape 21 indique si le syndrome est nul, que la décision ferme des valeurs a priori $ap_{il}^{(j)}$ est un mot du code $C_i$ et ne contient aucune erreur. Les valeurs extrinsèques peuvent être mises à 0 simplement. Dans un mode préférentiel de l'invention, au prix d'une augmentation très faible de la complexité, elles peuvent être calculées à l'étape 22 en appliquant un retraitement incluant un ordre 1 total sur cette décision ferme afin de définir un ensemble qui induit le calcul des valeurs extrinsèques selon les relations (7) et/ou (8) et/ou (9) sans modification de la matrice de parité Là encore, le retraitement peut varier en fonction de l'itération. Le retraitement peut être choisi élevé pour les premières itérations mais doit toujours contenir un retraitement d'ordre 1 et pour les itérations suivantes, il peut être réduit au minimum du retraitement d'ordre 1.

Dans le déroulement de l'étape 14, les valeurs *a posteriori* sont représentées comme la somme des valeurs reçues et des valeurs extrinsèques pondérées non pas par des valeurs expérimentales mais par une valeur algorithmique. Ceci permet d'être totalement indépendant du code composant, de l'itération et du rapport signal sur bruit et induit un décodage itératif proposé par l'invention absolument générique.

Ainsi, si les valeurs extrinsèques sont non nulles (soit le syndrome est non nul soit les valeurs extrinsèques sont issues du procédé F réduit à la partie retraitement incluant un ordre 1 complet), l'invention dans un premier mode de mise en oeuvre de l'étape 14 préconise de définir les fiabilités *a posteriori* comme la somme des valeurs reçues et des valeurs extrinsèques pondérées :

$$app_{il}^{(j)} = y_{il} + f_1(e_{il},n_i)ext_{il}^{(j)} \tag{10}$$

OÙ $e_{il}$ est le nombre de valeurs différentes entre la décision ferme des valeurs a priori $ap^{(j)}$ et le mot ferme $C_{il}^{(F)}$ issu du décodage élémentaire du mot $u_{il}$. Dans ce cas, au sein de l'ensemble $U_i$ relatif au code $C_i$, les valeurs *a posteriori* des mots élémentaires $u_{il}$ sont traitées séparément. La fonction $f_1$ est une fonction qui peut être non linéaire mais qui doit dépendre du nombre eil. Par exemple, cette fonction peut prendre la forme

$$f_1(e_{il},n_i) = 1 - \left(\frac{e_{il}}{n_i}\right)^{\frac{1}{q}} \text{où} \quad q \in \mathbf{N}$$

où N est l'ensemble des entiers naturels. Le rapport

$$\left(\frac{e_{il}}{n_i}\right)$$

est appelé le taux de correction du mot $u_{il}$ de l'itération courante.

Dans un autre mode de réalisation, l'invention définit les valeurs *a posteriori* par la somme:

$$(app_{il}^{(j)})=(y_{il})+f_2(E,n_ip_i)(ext_{il}^{(j)}) \tag{21}$$

pour tout vecteur $(ext^{(j)})$ non nul et où $E$ est le nombre de valeurs différentes entre la décision ferme des valeurs a priori $(ap_{il}^{(j)})_{1\leq l\leq p_i}$ et les mots fermes $(C_{il}^{(F)})_{1\leq l\leq p_i}$ issus des décodages élémentaires des mots $(u_{il})_{1\leq l\leq p_i}$. Dans ce cas, les valeurs *a posteriori* dépendent du traitement total de l'ensemble $U_i$ et la fonction $f_2$ est une fonction qui peut être non linéaire mais qui doit dépendre du nombre $E$. Par exemple cette fonction peut prendre la forme

$$f_2(E,p_in_i) = 1 - \left(\frac{E}{p_in_i}\right)^{\frac{1}{q}} \quad \text{où} \quad q \in \mathbf{N} \quad \textbf{(12)}$$

Le rapport

$$\left(\frac{E}{p_in_i}\right)$$

est appelé le taux de correction de l'ensemble des mots de $U_i$ de l'itération courante.

Dans un mode préférentiel de mise en oeuvre du procédé selon l'invention, il est préconisé de n'avoir aucune valeur extrinsèque nulle. Cependant, si le coût modeste rajouté par l'application, lorsque le syndrome est nul, du procédé F réduit au retraitement est encore trop important, l'invention propose de calculer les valeurs *a posteriori* à partir des valeurs *a priori* des deux manières suivantes.

Si les valeurs extrinsèques sont nulles, cela signifie qu'aucun décodage n'a été effectué et que le mot $u_{il}$ correspondant est considéré comme ne comportant plus aucune erreur. C'est dans ce sens qu'il en est tenu compte pour la fonction $f_2$. En ce qui concerne la valeur a *posteriori*, elle correspond à la fiabilité qu'on veut bien accorder à un mot dont le syndrome est nul. Ainsi dans un autre mode de réalisation l'invention propose de définir les fiabilités *a posteriori* comme proportionnelles aux fiabilités *a priori:*

$$app_{il}^{(j)} = t_2^{(j)} ap_{il}^{(j)} \qquad (13)$$

où $t_2^{(j)}$ est un coefficient expérimental qui dépend de l'itération, du rapport signal sur bruit et également du code. Il est également possible de calculer les fiabilités *a posteriori* à partir de la décision ferme des valeurs *a priori* et de cette manière, plus aucune distinction n'est possible sur la fiabilité des symboles au sein du mot traité. Dans ce mode de réalisation les fiabilités *a posteriori* sont définies par

$$app_{il}^{(j)} = t_3^{(j)} ap_{il}^{(j)*-1} \qquad (14)$$

L'opération *-1 désigne l'inverse de la modulation et $t_3^{(j)}$ est toujours un coefficient expérimental qui dépend de l'itération, du rapport signal sur bruit et également du code.

Selon un premier mode de réalisation de l'étape 15, si au cours du traitement de $U_i$, tous les syndromes relatifs aux décisions fermes de $(ap_{il}^{(j)})_{1 \leq i \leq p_i}$ sont nuls, les mots $(u_{il})_{1 \leq i \leq p_i}$ ne comportent plus d'erreur détectable. Les itérations suivantes n'apporteront plus d'information susceptible de modifier la décision. La décision ferme des valeurs *a posteriori* est le décodage final.

Dans un autre mode de réalisation de l'étape 15 si lors du traitement de $U_i$, les nombres $(e_{il})_{1 \leq l \leq p_i}$ sont tous nuls en cas de traitement par mot élémentaire ou si $E=0$ en cas de traitement pour la totalité des mots de $U_i$, il est considéré que les itérations ont convergé et qu'il est inutile de poursuivre. Cette forme ne diffère de la première que lorsque le décodage a échoué. Ce critère comprend le premier mode de réalisation de l'étape 15 et il est donc plus global dans le sens où il permet pour les cas critiques de réduire les itérations inutiles quand le système a convergé.

La figure 7 illustre les performances obtenues par le code produit à deux dimensions construit à partir du code BCH étendu de paramètres (32,21). Le procédé P1 est utilisé dans sa version complètement générique. Les valeurs extrinsèques sont garanties non nulles avec à la première itération un retraitement d'ordre 2 pour tous les mots $u_{il}$ y compris lorsque le syndrome est nul puis un retraitement d'ordre 1 pour l'itérations suivante. Les valeurs *a posteriori* sont définies par la relation (12) et le nombre d'itération maximum est de 20. Par exemple à 2dB 74% des séquences émises nécessitent un décodage sur 4 itérations ( ce qui représente deux décodages de toutes les lignes puis de toutes les colonnes) et 25% nécessitent 6 itérations.

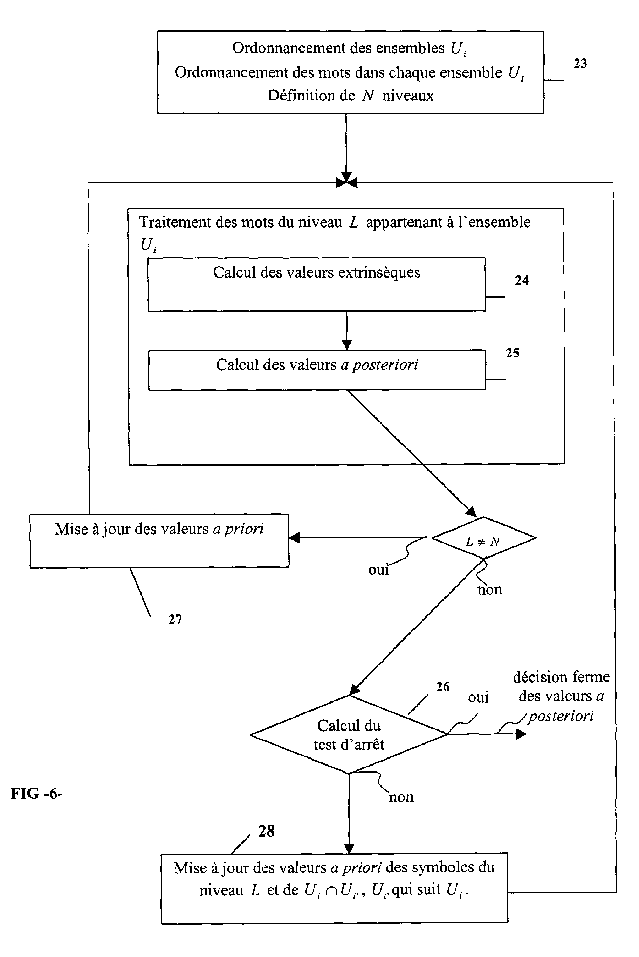

Suivant le deuxième mode de réalisation de l'invention le procédé selon l'invention, noté ci après P2, se déroule suivant les étapes référencées de 23 à 28 de la figure 6. Selon cette variante le procédé effectue un décodage itératif appliqué à une concaténation de $p$ codes selon un ordre des décodages élémentaires variables au cours des itérations et alternant des décodages au sein de chaque ensemble $U_i$.

Selon la première étape 23 , les mots de chaque ensemble $U_i$ sont ordonnés en niveaux. Chaque niveau est constitué de tous les mots des ensembles $U_i$ dont la fiabilité est de même ordre. La fiabilité associée au mot dépend du schéma de transmission qui doit être plus précisément connu. Elle peut donc être donnée par la démodulation ou par des informations fournies par le système de transmission extérieur au décodeur. Les décodages élémentaires sont alors ordonnés également par niveau. Tous les mots appartenant au niveau le plus fiable sont traités au sein de chaque ensemble $U_i$ eux mêmes ordonnés selon la première étape du procédé P1. Ensuite les décodages se font toujours par niveaux dans l'ordre décroissant de l'ordre des fiabilités associées. Si le système ne permet pas d'ordonner les mots dans l'ordre décroissant de leur fiabilité, il est toujours possible d'utiliser l'ordonnancement des ensembles $U_i$ selon le procédé déjà décrit à l'étape 12 du premier mode de réalisation.

Désormais une itération est définie comme l'ensemble des décodages de tous les mots des ensembles $U_i$ tous niveaux confondus. Le décodage itératif qui suit se base sur cet ordonnancement des décodages élémentaires.

Au cours de la deuxième étape 24 le procédé calcule les valeurs extrinsèques de tous les symboles par mot élémentaire appartenant à un niveau et à un ensemble $U_i$. Le décodage SISO élémentaire qui suit s'effectue de manière analogue au procédé P1 déjà décrit concernant le premier exemple de réalisation de l'invention.

Ce procédé se déroule selon 4 étapes élémentaires.

Dans un premier temps le syndrome relatif à la décision ferme des fiabilités *a priori* du mot de $U_i$ traité est calculé.

Si le syndrome est non nul, le procédé F est utilisé selon les deux variantes $F(C_1)$ ou $F(C_{il}^{(j)})$ pour construire l'ensemble . Les valeurs extrinsèques pour les nouveaux symboles utiles sont alors déterminées par la relation (7) ou dans un mode de réalisation plus complexe par la relation (8). Pour les symboles de redondance, leurs fiabilités sont également déterminées par les relations (7) ou (8) si l'ensemble contient au moins les mots $C_m^{(0)}$ et $C_m^{(1)}$ ou par la relation (9) dans un mode préférentiel de l'invention.

Si le syndrome est nul le procédé exécute des calculs identiques à ceux de l'étape 21 du premier mode de réalisation de l'invention.

Le calcul des valeurs *a posteriori* est effectué au cours d'une troisième étape 25. Dans ce calcul il n'est pas tenu compte de la totalité des informations des mots de $U_i$ car tous les mots de $U_i$ n'appartiennent pas à un même niveau.

Ainsi si les valeurs extrinsèques ne sont pas nulles, celles ci peuvent être calculées à partir de la relation (10) qui ne prend en compte que le mot traité.

Il est également possible suivant un autre mode de réalisation de prendre en compte tous les mots du niveau courant appartenant à $U_i$ et de calculer les valeurs a *posteriori* par la relation :

$$app_{il}^{(j)} = y_{il} + \mathrm{f}_3(E_{il},n_i l_i)ext_{il}^{(j)} \qquad (15)$$

où $E_{il}$ est le nombre de valeurs différentes entre la décision ferme des valeurs a priori des $l_i$ mots appartenant au niveau $l$ traité et à l'ensemble $U_i$, et les $l_i$ mots fermes issus des décodages élémentaires des $l_i$ mots $u_{il}$ appartenant à cette intersection.

La fonction $f_3$ est une fonction qui peut être non linéaire mais qui doit dépendre du nombre $E_{il}$. Elle peut prendre la forme

$$f_3(E_{il},l_i n_i) = 1 - \left(\frac{E_{il}}{l_i n_i}\right)^{\frac{1}{q}} \quad \text{où} \quad q \in \mathbb{N}.$$

Le rapport

$$\left(\frac{E_{il}}{l_i n_i}\right)$$

est appelé le taux de correction de l'ensemble des mots appartenant à l'intersection du niveau traité et de l'ensemble $U_i$.

L'invention préconise toujours de garantir des valeurs extrinsèques non nulles selon l'étape 22. Cependant dans le cas contraire, l'invention propose de définir les valeurs a posteriori selon les relations (12) ou (13).

La quatrième étape 26 a pour objectif d'arrêter les itérations. Une itération désigne le traitement de tous les ensembles $U_i$. Les décodages sont arrêtés lorsque le dernier niveau est atteint. A ce stade au cours du traitement de chaque ensemble $U_i$ il est possible d'arrêter les décodages en accord avec l'étape 15. Si tous les syndromes relatifs aux décisions fermes sont nuls les itérations suivantes n'apporteront plus d'informations susceptibles de modifier la décision, il est inutile de poursuivre et le décodage est la décision ferme des valeurs *a posteriori.* L'invention préconise d'utiliser comme critère d'arrêt la deuxième variante de l'étape 15. Si lors du traitement de $U_i$, les nombres $(e_{il})_{1 \leq i \leq p_i}$ sont tous nuls, en cas de traitement par mot élémentaire ou lorsque tous les nombres $(E_{il})$=0, en cas de traitement par ensemble de mots appartenant à l'intersection du dernier niveau et de l'ensemble $U_i$, il est considéré que les itérations ont convergé et qu'il est inutile de poursuivre. Là encore, le décodage est la décision ferme des valeurs *a posteriori.*

Dans le deuxième mode P2 de mise en oeuvre du procédé selon l'invention le nombre d'itérations se trouve être moins réduit que dans le premier puisqu'il faut attendre le dernier niveau pour procéder à un test d'arrêt. Cependant si l'ordonnancement des mots a été correctement effectué, l'itération est d'autant plus efficace.

La cinquième étape 27 consiste à déterminer les valeurs a *priori* pour le nouvel ensemble $U_{i'}$ qui va être traité au sein de l'itération courante pour un niveau identique ou supérieur. Le procédé consiste simplement comme pour l'étape 21 à reporter les valeurs *a posteriori* dans les valeurs *a priori* si le symbole est commun à l'ensemble $U_i$ et $U_{i'}$. Dans cette deuxième variante du procédé selon l'invention il est clair que les valeurs *a priori* peuvent être issues de plusieurs décodages successifs et donc avoir des valeurs très hétérogènes d'où l'influence d'autant plus importante de l'ordonnancement et son efficacité.

Dans une dernière étape 28, il s'agit lorsqu'une itération complète a été réalisée et que le critère d'arrêt n'est pas valide, de redéfinir les nouveaux niveaux. Ceci peut être obtenu soit en reprenant le calcul des fiabilités par mot induit par un système extérieur au décodeur s'il existe, soit en définissant la fiabilité accordée à un mot en fonction du nombre de corrections que l'itération précédente lui a apportées. Plus ce nombre est important moins le mot peut être considéré comme fiable ce qui permet de définir ces niveaux de fiabilités, et les décodages élémentaires par niveaux dans l'ordre décroissant des fiabilités sont repris.

**Revendications**

**1.** Procédé de décodage itératif pour toutes concaténations d'un nombre déterminé $p$ de codes en blocs, ou assimilés, binaire ou à écriture binaire, par décomposition en décodages élémentaires au moyen d'un décodeur du type à "entrée souple/sortie souple", permettant à partir d'une information dite de fiabilité *a priori* sur les symboles émis du code, de calculer des valeurs de fiabilités *a posteriori* dans lequel les valeurs de fiabilité *a posteriori* deviennent des valeurs de fiabilité *a priori* pour initialiser le décodage à chaque nouvelle itération, les valeurs de fiabilité *a posteriori* étant calculées à partir d'une valeur dite valeur extrinsèque qui tient compte des informations disponibles sur chacun des symboles reçus, **caractérisé en ce qu'**il consiste:

- à ordonnancer (12) à chaque itération les décodages élémentaires en $p$ ensembles $U_i$ de mots relatifs à chaque code $C_i$ dans l'ordre décroissant de leur nombre de dépendance avec les mots reçus et de la capacité de correction des codes,

- à garantir le calcul (13) des valeurs extrinsèques des symboles représentés dans chaque ensemble $U_i$ par un décodage élémentaire de chaque mot de l'ensemble $U_i$,

- à calculer des valeurs *a posteriori* de chaque symbole représenté dans chaque ensemble $U_i$ (14) en effectuant la somme des valeurs reçues et des valeurs extrinsèques pondérées en fonction du nombre de symboles différents entre la décision ferme des valeurs a priori et la décision ferme issue des décodages élémentaires de l'itération courante,

- et à arrêter les itérations (15) en fonction du même nombre de symboles différents entre la décision ferme des valeurs a priori et la décision ferme issue des décodages élémentaires de l'itération courante, pour ne conserver que la décision ferme des dernières valeurs a posteriori.

**2.** Procédé selon la revendication 1 **caractérisé en ce qu'**il consiste à ordonner (23) chaque ensemble $U_i$ de mots relatifs à chaque code $C_i$ par ordre décroissant de leur fiabilité, à construire (23) $N$ niveaux comprenant les mots de même ordre de fiabilité, à calculer (24) les valeurs *a posteriori* des symboles des mots des niveaux ordonnancés dans le sens décroissant de la fiabilité de ses mots et des ensembles $U_i$ ordonnancés dans le sens décroissant de leur nombre de dépendance avec les valeurs reçues et de leur capacité de correction, par décodage élémentaire de chacun des mots des intersections.

**3.** Procédé selon l'une quelconque des revendications 1 et 2 **caractérisé en ce que** le décodage élémentaire d'un mot relatif au code $C_i$ a lieu par exécution d'un algorithme de type Fossorier consistant à trier (7) les plus petites valeurs de fiabilité des symboles reçus dans un ordre décroissant de leur valeur absolue pour engendrer une première permutation $\Pi_1$, à déterminer (8) un code $C'_i$ équivalent au code $C_i$ par mise en forme systématique de la matrice de parité permutée par $\Pi_1$ ou de la matrice génératrice permutée par $\Pi_1$, à engendrer une deuxième permutation $\Pi_2$ pour déterminer les nouveaux symboles utiles dont les fiabilités contiennent le plus grand nombre des $k_i$ plus grandes valeurs reçues en valeur absolue, à construire (9) à partir des décisions fermes des nouveaux symboles utiles un mot $C^{(0)}$ candidat appartenant au code $C'_i$, à appliquer (10) sur les symboles utiles de $C^{(0)}$ des motifs d'erreurs pour définir un ensemble de mots $C^{(i)}$ candidats appartenant au code $C'_i$ et à calculer (11) une distance choisie entre les mots $C^{(i)}$ relativement au mot souple reçu permuté par le produit des permutations $\Pi_1$ et $\Pi_2$.

**4.** Procédé selon l'une quelconque des revendications 1 et 2 **caractérisé en ce que** le décodage élémentaire d'un mot relatif au code $C_i$ a lieu par exécution d'un algorithme de type Fossorier consistant à permuter les valeurs de fiabilité des symboles reçus selon la dernière permutation mémorisée lors du précédent traitement du mot, à trier (7) les plus petites valeurs de fiabilité de ces symboles reçus permutés dans un ordre décroissant de leur valeur absolue pour engendrer une première permutation $\Pi_1$, à déterminer (8) un code $C'_i$ équivalent au code $C_i$ par mise en forme systématique de la matrice de parité mémorisée lors du précédent traitement du mot courant per-

mutée par $\Pi_1$ ou de la matrice génératrice mémorisée lors du précédent traitement du mot courant permutée par $\Pi_1$, à engendrer une deuxième permutation $\Pi_2$ pour déterminer les nouveaux symboles utiles dont les fiabilités contiennent le plus grand nombre des $k_i$ plus grandes valeurs reçues en valeur absolue, à construire (9) à partir des décisions fermes des nouveaux symboles utiles un mot $C^{(0)}$ candidat appartenant au code C'$_i$, à appliquer (10) sur les symboles utiles de $C^{(0)}$ des motifs d'erreurs pour définir un ensemble de mots $C^{(i)}$ candidats appartenant au code $C'_i$, à calculer (11) une distance choisie relativement au mot souple reçu permuté par le produit des permutations $\Pi_1$, $\Pi_2$ et $\Pi$, et à mémoriser la mise à jour de la permutation $\Pi = \Pi_2 o \Pi_1 o \Pi$ et la matrice issue de la mise en forme systématique.

**5.** Procédé selon les revendications 1 à 4 **caractérisé en ce qu'**il consiste à calculer (17) un syndrome par le produit dans le corps de Galois du code du vecteur des décisions fermes des valeurs *a priori* par la matrice de parité du code C$_i$ transposée avant de calculer les valeurs extrinsèques.

**6.** Procédé selon les revendications 1 à 5 **caractérisé en ce qu'**il consiste si le syndrome du mot traité n'est pas nul à effectuer (19) un calcul des valeurs extrinsèques des nouveaux symboles utiles à partir de deux mots concurrents du code équivalent C'$_i$ appartenant à l'ensemble déterminé en appliquant le décodage à entrée et sortie souple par ré-ordonnancement et retraitement avec une phase de retraitement incluant un ordre 1.

**7.** Procédé selon les revendications 1 à 5 **caractérisé en ce qu'**il consiste si le syndrome du mot traité est nul à effectuer (22) un calcul des valeurs extrinsèques des nouveaux symboles utiles à partir de deux mots concurrents du code équivalent C'$_i$ appartenant à l'ensemble déterminé en appliquant le décodage à entrée et sortie souple réduit à l'étape de retraitement incluant un ordre 1.

**8.** Procédé selon les revendications 1 à 7 **caractérisé en ce qu'**il consiste à choisir un retraitement variable pour chaque itération, avec un fort retraitement pour les premières et un retraitement plus faibles pour les dernières avec toujours un retraitement incluant un ordre 1 au minimum.

**9.** Procédé selon les revendications 1 à 5 **caractérisé en ce qu'**il consiste à calculer (20) les valeurs extrinsèques des nouveaux symboles de redondance en utilisant la relation de parité entre le symbole de redondance et les symboles utiles.

**10.** Procédé selon la revendication 9 **caractérisé en ce que** les valeurs extrinsèques des *n-k* nouveaux symboles de redondance sont définis par la relation de parité qui les lient aux *k* symboles utiles par la relation

$$ext_m = sign(\prod_{q=1}^{k} h_{(m-k)q}(d_q^{(1)} - d_q^{(0)})) \min_{1 \le q \le k}\left(\left\|h_{(m-k)q}(d_q^{(1)} - d_q^{(0)})\right\|\right) - ap_m \quad k+1 \le m \le n-k$$

où $d_q^{(1)}$, $d_q^{(0)}$ sont les métriques des deux mots concurrents associés aux symboles utiles $(s_q)_{1\le q\le k}$.et où l'équation de parité est donnée par

$$\sum_{q=1}^{k} h_{(m-k)q} s_q = 0$$

dans le corps de Galois du code.

**11.** Procédé selon les revendications 1 à 5 **caractérisé en ce qu'**il consiste à calculer (20) à calculer les valeurs extrinsèques des nouveaux symboles de redondance par utilisation des mots concurrents s'ils existent.

**12.** Procédé selon les revendications 1 à 5 **caractérisé en ce qu'**il consiste si le syndrome du mot traité est nul à mettre à 0 les valeurs extrinsèques pour limiter la complexité.

**13.** Procédé selon les revendications 1 à 11 **caractérisé en ce qu'**il consiste à calculer les valeurs *a posteriori* en effectuant la somme des valeurs reçues et d'une pondération des valeurs extrinsèques lorsqu'elles sont non nulles, cette pondération étant fonction du taux de corrections apportées au mot élémentaire au cours de son décodage.

**14.** Procédé selon la revendication 12 **caractérisé en ce que** la fonction du taux de correction est définie par la relation:

$$f_1(taux) = 1 - taux^{\frac{1}{q}}, q \in \mathbb{N}$$

**15.** Procédé selon les revendications 2 à 13 **caractérisé en ce qu'**il consiste à calculer des valeurs *a posteriori* par la somme des valeurs reçues et d'une pondération des valeurs extrinsèques lorsqu'elles sont non nulles, cette pondération est fonction du taux de corrections apportées à l'ensemble des mots élémentaires appartenant soit à un ensemble $U_i$ soit à l'intersection de l'ensemble $U_i$ et du niveau traité au cours de leur décodage .

**16.** Procédé selon les revendications 1 à 11 dans lequel les valeurs extrinsèques induisent des valeurs a posteriori proportionnelles aux valeurs *a priori* si les valeurs extrinsèques sont nulles, le coefficient de proportionnalité étant prédéfini.

**17.** Procédé selon les revendications 1 à 11 dans lequel les valeurs extrinsèques induisent des valeurs *a posteriori* proportionnelles aux décisions fermes des valeurs *a priori* modulées, le coefficient de proportionnalité étant prédéfini..

**18.** Procédé selon l'une quelconque des revendications 1 à 17 selon lequel les itérations sont arrêtées si tous les syndromes des mots élémentaires appartenant à $U_i$ sont nuls.

**19.** Procédé selon l'une quelconque des revendications 2 à 17 selon lequel les itérations sont arrêtées si tous les syndromes des mots élémentaires appartenant à l'intersection de $U_i$ et du dernier niveau traité sont nuls.

**20.** Procédé selon l'une quelconque des revendications 1 à 17 selon lequel les itérations sont arrêtées si le taux de corrections de chaque mot élémentaire appartenant à $U_i$ est nul.

**21.** Procédé selon l'une quelconque des revendications 2 à 17 selon lequel les itérations sont arrêtées si tous les taux de corrections des mots élémentaires appartenant à l'intersection de $U_i$ et du dernier niveau traité sont nuls.

FIG -1-

Source binaire **1** → Codeur **2** → Modulateur **3** → Canal **4** → Démodulateur **5** → Décodeur **6**

A   B   C   D   E   F

| | |
|---|---|
| Tri décroissant des fiabilités | **7** |

fiabilités sur les bits

$$C' = \Pi_2 \circ \Pi_1(C) \, .$$

Détermination du code — **8**

Construction du mot $C_{(0)} \in C'$ — **9**

Construction de l'ensemble des mots candidats — **10**

Choix du mot de — **11**

Bits décodés

FIG -2-

Retour pour l'itération suivante

Valeurs *a priori*

Valeurs *a priori*

Décodage à
entrée/sortie
souples

Décodage à
entrée/sortie
souples

Valeurs reçues

Valeurs *a posteriori*

**FIG-3-**

**FIG - 7 -**

**EP 1 217 752 A2**

**FIG -4-**

Les valeurs *a priori* d'un
mot élémentaire de $U_i$

→ | Calcul du syndrome | — 17

↓

◇ Syndrome nul ◇

non ← | Application du procédé F | 18

19 | Calcul des valeurs extrinsèques des nouveaux symboles utiles |

20 | Calcul des valeurs extrinsèques des nouveaux symboles de redondance |

oui →

21 | Mises à 0 de toutes les valeurs extrinsèques |

22 | Application du procédé F restreint au décodage par retraitement |

**FIG-5-**

18

Ordonnancement des ensembles $U_i$
Ordonnancement des mots dans chaque ensemble $U_i$
Définition de $N$ niveaux

**23**

Traitement des mots du niveau $L$ appartenant à l'ensemble $U_i$

Calcul des valeurs extrinsèques

**24**

Calcul des valeurs *a posteriori*

**25**

Mise à jour des valeurs *a priori*

**27**

$L \neq N$

oui

non

décision ferme des valeurs *a posteriori*

**26** oui

Calcul du test d'arrêt

non

**FIG -6-**

**28**

Mise à jour des valeurs *a priori* des symboles du niveau $L$ et de $U_i \cap U_{i'}$, $U_{i'}$ qui suit $U_i$.